# EUROPEAN PATENT SPECIFICATION

(11) **EP 3 216 325 B1**
(45) Date of publication and mention of the grant of the patent: **12.06.2024**
(21) Application number: 15788423.0
(22) Date of filing: 03.11.2015
(51) Int. Cl.: H05K 1/02, H05K 7/20, F28D 15/02

(54) **CIRCUIT BOARD WITH INTEGRATED PREFABRICATED HEAT PIPE AND REINFORCED HEAT PIPE**
LEITERPLATTE MIT INTEGRIERTEM VORGEFERTIGTEM WÄRMEROHR UND VERSTÄRKTEM WÄRMEROHR
CARTE DE CIRCUIT IMPRIMÉ COMPRENANT UN CALODUC PRÉFABRIQUÉ ET CALODUC RENFORCÉ

(30) Priority: 03.11.2014 DE 102014116001
(43) Date of publication of application: 13.09.2017
(73) Proprietor: AT & S Austria Technologie & Systemtechnik Aktiengesellschaft, 8700 Leoben (AT)
(72) Inventor: SILVANO DE SOUSA, Jonathan, 1100 Wien (AT); LEITGEB, Markus, 8793 Trofaiach (AT)
(74) Representative: Donatello, Daniele
(86) International application number: PCT/EP2015/075574
(87) International publication number: WO 2016/071327

(56) References cited:
- JP-A- H05 121 846
- JP-A- 2006 041 024
- JP-A- 2013 007 545
- US-A1- 2003 102 118
- US-A1- 2007 131 448
- US-A1- 2012 033 385

## Description

The invention relates to a circuit board, a method of manufacturing a circuit board, an electronic arrangement, a hermetically sealed heat pipe, and a method of manufacturing a hermetically sealed heat pipe.

In the context of growing product functionalities of mounting devices equipped with one or more electronic components and increasing miniaturization of such electronic components as well as a rising number of electronic components to be mounted on mounting devices such as printed circuit boards, increasingly more powerful array-like components or packages having several electronic components are being employed, which have a plurality of contacts or connections, with ever smaller spacing between these contacts. Removal of heat generated by such electronic components and the mounting device itself during operation becomes an increasing issue. At the same time, mounting devices shall be mechanically robust so as to be operable even under harsh conditions.

A condenser for an LED substrate has been demonstrated (28th Annual IEEE Semiconductor Thermal Measurement and Management Symposium, SEMITHERM Symposium, 18-22 March 2012, San Jose, California, USA). Heat pipes are commonly used in modules for high power applications, CPU centric PCs, mainframes, etc. Heat pipes are also used in smartphones (NEC, Xperia 2).

US 2012/033385 A1 discloses a multilayer circuit board with a hermetically sealed heat pipe fully embedded within the interior of the circuit board.

Further background art in terms of heat removal is disclosed in US 6,935,022, US 5,268,812, US 5,095,404, US 6,082,443, US 8,072,763 and WO 2007/096313.

It is an object of the invention to provide a circuit board which allows to efficiently remove heat during operation while simultaneously having robust properties under typical manufacturing and operating conditions of the circuit board.

In order to achieve the object defined above, a circuit board and a method of manufacturing a circuit board according to the independent claims are provided.

According to another exemplary embodiment of the invention, an electronic arrangement is provided which comprises a circuit board having the above mentioned features, and at least one heat generating electronic component mounted on (for instance surface mounted on an exterior surface of) and/or in (for instance embedded in an interior of) the circuit board so that at least a part of heat generated by the at least one electronic component is conducted away from the at least one electronic component by the heat pipe.

In the context of the present application, the term "heat pipe" may particularly denote a heat-transfer member that combines the principles of both thermal conductivity and phase transition of a fluid in an interior of the heat pipe to efficiently manage the transfer of heat between two solid interfaces. At a hot interface of a shell of the heat pipe the fluid in a liquid phase in contact with a thermally conductive solid surface turns into a gas/vapor by absorbing heat from that surface. The gas/vapor then travels, guided by a guiding structure, along the heat pipe to a cold interface of the shell and condenses back into a liquid, thereby releasing the latent heat or phase transition heat. The liquid then returns, guided by the guiding structure, to the hot interface through one or more mechanisms such as capillary action, centrifugal force, gravity, or the like, and the cycle repeats. However, heat pipes may also use another heat transporting medium than a fluid, for instance a solid such as wax.

In the context of the present application, the term "prefabricated" may particularly denote that the manufacturing procedure of forming the heat pipe has already been finished before starting with the connection of the heat pipe to the layer structures. Hence, the prefabricated heat pipe may also be denoted as a preformed heat pipe or a readily manufactured heat pipe. Consequently, the heat pipe is embedded in or attached to the plurality of layer structures as a separate member or component rather than being constituted by the formation and patterning of individual layers to thereby form a monolithically integrated heat pipe.

In the context of the present application, the term "hermetically sealed" may particularly denote that fluid communication between an interior of the heat pipe and an exterior thereof is disabled. Hence, a fluid enclosed within an exterior shell of the heat pipe is prevented from leaving the heat pipe.

According to an exemplary embodiment, a readily manufactured or preformed heat pipe is used as an already existing member which is connected to interconnected layer structures of dielectric and electrically conductive material to thereby form a circuit board with integrated heat pipe. By integrating a prefabricated heat pipe into the circuit board during or after manufacture rather than forming or constituting the heat pipe from patterned layers during forming the layer structures has the advantage that the technically challenging procedure of insertion of fluid into an interior of the hermetically sealed heat pipe can already be finished before starting the circuit board formation procedure.

By integrating a prefabricated heat pipe member into a circuit board according to an exemplary embodiment, the technical prejudice had to be overcome that the combination of a prefabricated heat pipe member with circuit board technology is incompatible with the high soldering temperatures of 220°C or more which may occur during surface mounting of electronic components (such as electronic chips) on a mounting surface of the circuit board. It has been believed that the fluid within the hermetically sealed heat pipe would generate such a high pressure in an interior of the heat pipe at the mentioned soldering temperatures that the heat pipe would explode under such conditions. However, the present inventors have invented various ways of combining a preformed heat pipe with an interconnected layer structure arrangement without the risk of damage of the circuit board or part thereof and without danger for a user. In particular, mechanical reinforcement of the heat pipe for preventing the above described failure can be accomplished by intrinsically reinforcing the heat pipe itself or by reinforcing the heat pipe by surrounding at least part thereof with material of the connected layer structures which then, in turn, functions as reinforcing material.

In the following, further exemplary embodiments of the circuit board and the method of manufacturing a circuit board will be explained.

In an embodiment, the circuit board is configured as one of the group consisting of a printed circuit board, an IC substrate, and an interposer. Other types of circuit boards can be implemented as well.

In the context of the present application, a "printed circuit board" (PCB) may denote a board of an electrically insulating core (in particular made of a compound of glass fibers and resin) covered with electrically conductive material and conventionally serving for mounting thereon one or more electronic members (such as packaged electronic chips, sockets, etc.) to be electrically coupled by the electrically conductive material. More specifically, a PCB may mechanically support and electrically connect electronic components using conductive tracks, pads and other features etched from metal structures such as copper sheets laminated onto an electrically non-conductive substrate. PCBs can be single sided (i.e. may have only one of its main surfaces covered by a, in particular patterned, metal layer), double sided (i.e. may have both of its two opposing main surfaces covered by a, in particular patterned, metal layer) or of multi-layer type (i.e. having also one or more, in particular patterned, metal layers in its interior). Conductors on different layers may be connected to one another with plated-through holes which may be denoted as vias. PCBs may also contain one or more electronic components, such as capacitors, resistors or active devices, embedded in the electrically insulating core.

In the context of the present application, an "interposer" may denote an electrical interface device routing between one connection to another. A purpose of an interposer may be to spread a connection to a wider pitch or to reroute a connection to a different connection. One example of an interposer is an electrical interface between an electronic chip (such as an integrated circuit die) to a ball grid array (BGA).

In the context of the present application, an "IC substrate" (integrated circuit substrate) may denote a physical body, for instance comprising a ceramic and/or glass material, onto which electronic components are to be mounted.

In an embodiment, the electrically insulating material comprises at least one of the group consisting of resin, in particular Bismaleimide-Triazine resin, glass fibers, prepreg material, polyimide, liquid crystal polymer, epoxy-based Build-Up Film, and FR4 material. The resin material may serve as a matrix material having the desired dielectric properties and being cheap and highly appropriate for mass production. The glass fibers may reinforce the circuit board and may stabilize it mechanically. Furthermore, the glass fibers may introduce an anisotropic property of the respective circuit board, if desired. Prepreg is a suitable material for the circuit board, since it is already a mixture of resin and glass fibers which can be further processed (and particular tempered) for converting it into PCB type dielectric material. FR4 is a flame-resistant dielectric material for PCBs which can be suitably used for the packaging concept according to exemplary embodiments.

It should furthermore be said that the electrically conductive material which may form an electrically and/or thermally conductive contact structure can be made of a metal such as aluminum or copper. Copper is particularly preferred in view of its high electric and thermal conductivity and its compatibility with PCB technology.

In an embodiment, the heat pipe comprises a thermally conductive exterior shell (for instance made of copper), a fluid (such as water) enclosed in an interior of the shell and configured to be evaporated from a liquid phase into a gas phase (which may include a vapor phase) in the presence of heat at a portion of the shell, and a guiding structure (which may comprise one or more narrow channels through which the fluid may flow under the influence of a capillary action or similar effects) in an interior of the shell configured for guiding the evaporated gas phase from said portion to another cooler portion of the shell to thereby condense the fluid from the gas phase into the liquid phase, and for guiding back the condensed fluid towards said portion. Thus, the described hermetically sealed structure may allow for a highly efficient heat transfer while being able to be operated in a closed cycle manner. Such a heat pipe can also be manufactured in advance of the circuit board formation procedure so that in particular the fluid insertion may be carried out before integrating the heat pipe structure into or onto the plurality of interconnected layer structures. The guiding structure may be realized by a sinter body, grooves, microprotrusions and/or microrecesses, channels, and/or a surface roughness at an interior surface of the shell.

However, in alternative embodiments, the fluid may be substituted by another heat transporting medium. For example, the fluid can be replaced with a solid (for example wax) depending on the respective application.

In an embodiment, the circuit board comprises a heat source coupling structure made of thermally conductive material and being configured for thermally coupling a portion (for instance a first end) of the heat pipe to a heat source mounting position of the circuit board at which heat source mounting position at least one heat generating electronic component is to be mounted. Such a heat source coupling structure may comprise one or more vias as vertical interconnections and/or may comprise patterned thermally conductive structures of the plurality of connected layer structures. Advantageously, the heat source coupling structure may be made of copper which is anyway present in PCB technology due to its high electric conductivity, but which simultaneously has also a very high thermal conductivity which renders this material particularly appropriate as heat source coupling structure. The heat source mounting position may be on a main surface of the plurality of connected layer structures so that the heat source can be mounted on the circuit board as a surface mounted device (SMD). It is however also possible that the heat source mounting position is within an interior of the plurality of connected layer structures, for instance when the heat source is an embedded component. The heat source may be an electronic component generating heat during operation, which heat is to be removed using the prefabricated heat pipe for cooling purposes.

Such a heat source, when being embodied as electronic component, may particularly denote any active electronic component (such as an electronic chip, in particular a semiconductor chip) or any passive electronic component (such as a capacitor). Examples of the embedded components are a data storage memory such as a DRAM (or any other memory), a microcontroller, a filter (which may for instance be configured as a high pass filter, a low pass filter or a bandpass filter, and which may for instance serve for frequency filtering), an integrated circuit (such as a logic IC), a signal processing component (such as a microprocessor), a power management component, an optical electrically interfacing member (for instance an optoelectronic member), a voltage converter (such as a DC/DC converter or an AC/DC converter), a cryptographic component, a capacitor, an inductance, a switch (for instance a transistor-based switch) and a combination of these and other functional electronic members.

In an embodiment, the circuit board comprises a heat sink coupling structure made of thermally conductive material and being configured for thermally coupling a portion (for instance a second end) of the heat pipe to a heat sink mounting position of the circuit board at which heat sink mounting position a heat sink is to be mounted. Such a heat sink coupling structure may comprise one or more vias as vertical interconnections and/or may comprise patterned thermally conductive structures of the plurality of connected layer structures. Advantageously, the heat sink coupling structure may be made of copper which is anyway present in PCB technology due to its high electric conductivity, but which simultaneously has also a very high thermal conductivity which renders this material particularly appropriate as heat sink coupling structure. Examples for suitable heat sinks are cooling bodies having cooling fins, a copper block for example, in/on lay structures placed in the PCB), an aluminum block, a housing of the circuit board, any other cooling body or the like. A heat sink may also be a fluid-based (for instance water-based) cooling member attached to the circuit board.

In an embodiment, the circuit board comprises the heat sink mounted at the heat sink mounting position, in particular being arranged at one of a main surface of the circuit board, and a lateral surface of the circuit board. Mounting the heat sink (for instance by soldering, a thermally conductive adhesive, thermal compression bonding, etc.) on the main surface allows to use also large dimensioned heat sinks which efficiently remove a large amount of heat from the circuit board. Mounting the heat sink on a (usually non-used) lateral surface of a sheet-shaped or plate-shaped circuit board may however allow to use the main surface(s) of the circuit board very efficiently for mounting electronic components thereon, thereby rendering the circuit boards highly efficient and also compact. Conventionally, there has been the prejudice that attaching a heat pipe to an exterior of a circuit board would involve the high risk of an explosion of the heat pipe due to the high pressure of an evaporating fluid in an interior of the heat pipe under thermal load (for instance during a soldering procedure). However, by mechanically reinforcing a heat pipe and/or by mounting the heat pipe on the circuit board after finishing the surface mounting of electronic components thereon in fact allows to mount heat pipes on a main surface of the circuit board without failure.

The heat pipe is fully embedded within an interior of the layer structures. It has further been cognized by the present inventors that fully circumferentially surrounding an exterior surface of the prefabricated heat pipe with material of the plurality of connected layer structures allows to apply an exterior pressure onto the shell of the heat pipe which prevents failure even in the event of a high temperature acting on the heat pipe and therefore a high pressure generated by the fluid in an interior of the heat pipe. Such an event of a high heat impact on the heat pipe may occur for instance during surface mounting electronic components on the circuit board.

The heat pipe itself comprises a reinforcement structure configured for reinforcing mechanical stability of the heat pipe. Additionally to full embedding of the heat pipe by surrounding material of the plurality of connected layer structures, it is also possible to specifically provide a reinforcement feature to a commercially available heat pipe in order to make the reinforced heat pipe capable to withstand high mechanical load in the event of a high thermal impact (by the high internal pressure of fluid evaporated to a high temperature). Another appropriate reinforcement feature is to add an ingredient or constituent capable of increasing thermal conduction capabilities or thermal guiding properties, for instance by using carbon fiber or carbon nanotubes (CNT). Thus, retrofitting commercially available heat pipes by equipping them with a reinforcement structure to render them usable as circuit board integrated heat pipes is possible according to an exemplary embodiment of the invention.

In an embodiment, the reinforcement structure is configured so that the heat pipe withstands a gas pressure of fluid evaporated within an interior of the heat pipe at least up to a temperature of 220°C. 220°C is a typical soldering temperature to which the circuit board or parts thereof can be exposed when one or more electronic components is or are soldered on top of the circuit board during surface mounting. Since the thermal impact acting on components of the circuit board and hence also on the heat pipe is usually the highest during such soldering, it is sufficient to configure the reinforcement structure to guarantee mechanical integrity of the heat pipe up to at least 220°C.

In one embodiment, a commercially available readily manufactured heat pipe may be made subject of a reinforcement treating before connection to the layer structures of the circuit board, i.e. may be retrofitted to make it appropriate for circuit board applications. In another embodiment, the reinforcement treating may be carried out during manufacturing the heat pipe, but also before connecting it to the layer structures of the circuit board.

The reinforcement structure comprises at least one of the group consisting of reinforcement filler particles (in particular made of polytetrafluoroethylene or Teflon, or Kevlar, Nomex, etc.) embedded in a shell of the heat pipe, an exterior material of a shell of the heat pipe (having a higher mechanical strength than an interior material of a guiding structure in an interior of the shell configured for guiding, within the shell, evaporated fluid in a gas phase from a portion to another cooler portion of the shell to thereby condense the fluid from the gas phase into the liquid phase, and for guiding back the condensed fluid towards said portion), and a reinforcement coating surrounding a shell of the heat pipe. Reinforcement filler particles are embedded in the material of the shell of the heat pipe, for instance in a copper shell. Advantageously, such filler particles do not only improve the mechanical robustness of the heat pipe, but are also made of a thermally conductive material (such as carbon fibers, carbon nanotubes (CNT), etc.) to thereby contribute also to the heat removal during operation. It is however also possible that filler particles are implanted into the shell of the heat pipe, for instance by ion implantation, which also increases the mechanical robustness. According to yet another embodiment, the entire heat pipe may be coated or covered with an applied layer or structure having reinforcing mechanical properties.

In an embodiment, the heat pipe is configured and electrically connected to the electrically conductive material so that the heat pipe provides an electric function. Hence, the heat pipe may also serve as part of the electrical circuit of the PCB, since it may also be made of copper. Thus, it may function as an electronic component or in cooperation with another electronic component. For example, it may serve as an electric trace for carrying signals or energy, as a resistor, a capacitor, an inductance, etc. The heat pipe can be made of electrically conductive material such as copper and, for that reason, can also be used as electrical connector in the electric circuit of the PCB (for example as ground).

In an embodiment, the method further comprises reinforcing the hermetically sealed prefabricated heat pipe with a reinforcement structure before contacting the heat pipe with the at least one of the layer structures. Before integrating the heat pipe into the layer structures, it is more easily accessible for carrying out a reinforcement procedure.

In an embodiment, the method further comprises fully embedding the heat pipe in an interior of the plurality of layer structures before or during the connecting. According to this embodiment, the entire exterior surface of the heat pipe is surrounded by material of the connected layer structures so that the high pressure of evaporated fluid within the heat pipe during high temperature conditions experiences a counter pressure from the surrounding material, to thereby prevent explosion or other kind of mechanical degradation of the heat pipe.

In an embodiment, the method further comprises connecting the plurality of layer structures with the embedded heat pipe by pressing together the plurality of layer structures and the embedded heat pipe. By this pressing procedure, the heat pipe may be immobilized in an interior of the circuit board so as to be capable of withstanding harsh conditions.

For providing a proper thermal coupling between the heat pipe and the connected layer structures, the heat pipe may be welded onto electrically conductive material (such as a copper foil, a copper inlay, a copper block or the like) of the layer structures and/or a heat source to be cooled.

The aspects defined above and further aspects of the invention are apparent from the examples of embodiment to be described hereinafter and are explained with reference to these examples of embodiment.

The invention will be described in more detail hereinafter with reference to examples of embodiment but to which the invention is not limited.
Figure 1 to Figure 4 illustrate cross sectional views of structures obtained during carrying out a method of manufacturing a circuit board according to an exemplary embodiment of the invention.
Figure 5 illustrates a cross sectional view of a prefabricated heat pipe for integration into layer structures for forming a circuit board according to another exemplary embodiment of the invention.
Figure 6 illustrates a cross sectional view of a prefabricated heat pipe reinforced by a reinforcement structure for attachment on layer structures for forming a circuit board according to another exemplary embodiment of the invention.
Figure 7 and Figure 8 illustrate cross sectional views of structures obtained during carrying out a method of manufacturing a circuit board according to an example not belonging to the invention.
Figure 9 and Figure 10 illustrate cross sectional views of printed circuit boards according to an example not belonging to the invention (Fig. 9) and an exemplary embodiment of the invention (Fig. 10).

The illustrations in the drawings are schematical. In different drawings, similar or identical elements are provided with the same reference signs.

Before exemplary embodiments and examples will be described in further detail referring to the figures, some general considerations of the present inventors will be presented based on which exemplary embodiments have been developed.

Heat pipes are already used in the industry to improve thermal management performance of electronic devices. The maximum temperature range for assembly and operation has to be kept at low temperature (usually below 140°C) in order not to destroy the heat pipe. Therefore, such a conventional prefabricated heat pipe cannot be assembled on a bare PCB, because the following reflow cycles for SMT (surface mounting technology) assembly would destroy the heat pipe.

One exemplary embodiment of the invention provides an embedded heat pipe being circumferentially embedded in layer structures of a circuit board. This embodiment of the invention is based on the idea of using the embedding processes to embed a heat pipe into the PCB, which offers the following significant advantages:
- During the embedding process, the melting of prepreg material of the layer structures is encapsulating and reinforcing the heat pipe and an isostatic pressure is created around the heat pipe. Therefore, the prepreg works as a counteracting force to the pressure, which is induced by heating up the liquid/gas in the heat pipe.
- The heat pipe can be connected with laser drilled copper vias, which enable proper heat transfer from the heat pipe to the heat sink. By inserting the heat pipe in the core of the PCB, the heat pipe can be introduced directly in the PCB contacting relevant areas where efficient heat transport is needed.

Furthermore, it is possible to form cavities in the PCB to embed thermal transport bodies. The insertion of the heat pipe via the cavity (opening of the PCB) may also avoid heat pipe reliability problems due to thermal stress that the PCB experiences during soldering of components (in particular reflow). There is no need of a chassis mount for the heat pipe(s) as it is done now for smartphones or tablets. The small dimensions of heat pipes (down to 400 µm and less) will allow the heat pipe to be designed for mobile devices and any other devices with severe spatial restriction. Hence, according to the described embodiment, a PCB can be equipped with one or more heat pipes. The assembly process is easy.

According to a further exemplary embodiment of the invention, one or more reinforced heat pipes are provided for PCB assembly. This embodiment is based on the idea of a reinforcement of the heat pipe which is compensating the vessel pressure caused by the liquid/gas inside the heat pipe due to temperature increase. One possible way for the reinforcement is a cover made of fibres, like aramide, nylon, glass, reinforced plastic, carbon fibres, etc. Thermally conductive fibers such as carbon fibres will additionally improve the heat transport performance of the heat pipe. Another way is to integrate the reinforcement already in the copper pipe (for instance by the use of composite materials, nano-particles, etc). Very thin conventional heat pipes are not intended to survive large heat stress as PCBs. To render them possible for PCB applications, they can be provided with a mechanical reinforcement in order to insert the mechanically reinforced heat pipe as part of the PCB body. The described embodiment has the advantage of an easy assembly process and the opportunity to ship the PCB with already inserted heat pipe(s) to a customer.

Due to the small diameter of the reinforced heat pipes, they may also be applied in applications with reduced size capabilities such as mobile devices. These heat pipe represent an economy of material. In the long term, it will represent a cost reduction regarding copper use for cooling. Since the heat pipes can be hollow copper structures, reinforced heat pipes inserted in the PCB drive to reduction of weight of the PCB.

In yet another exemplary embodiment, one or more heat pipes are integrated in a PCB body though cavity formation. This embodiment is based on the idea of forming an opening in a PCB, wherein the heat pipe can be mounted after the assembly process of the electronic device. This opening can be a cavity (to accomplish and access from the surface) or a lateral channel (to accomplish and access from the lateral side). In order to get a good thermal conductivity, the insertion of the heat pipe can be supported with thermal grease. By inserting the heat pipe in the core of the PCB, the heat pipe can be introduced directly in the PCB contacting relevant areas where efficient heat transport is needed. Hence, it is possible to form a cavity in the PCB to embed thermal transport bodies. The insertion of the heat pipe via the cavity (opening of the PCB) will avoid heat pipe reliability problems due to thermal stress that the PCB may experience for instance during soldering of components (in particular reflow). Also in this embodiment, there is no need of a chassis mount for the heat pipes as it is done for smartphones or tablets. The small dimensions (down to 400 µm or less) render the heat pipe appropriate for mobile devices and any other devices with severe spatial restrictions.

For instance, circuit boards with heat pipes according to exemplary embodiments of the invention can be used in the fields of automotive applications, lighting applications, mobile devices (such as smartphones, tablets, cameras powerbooks etc.), or power electronics. In particular for those applications, efficient board heat management solutions are required which can be fulfilled by the integrated heat pipe. Hence, embodiments of the invention may add technological value to the end product by making it possible to implement the heat pipes as thermal solutions directly as part of a PCBs ready to be shipped.

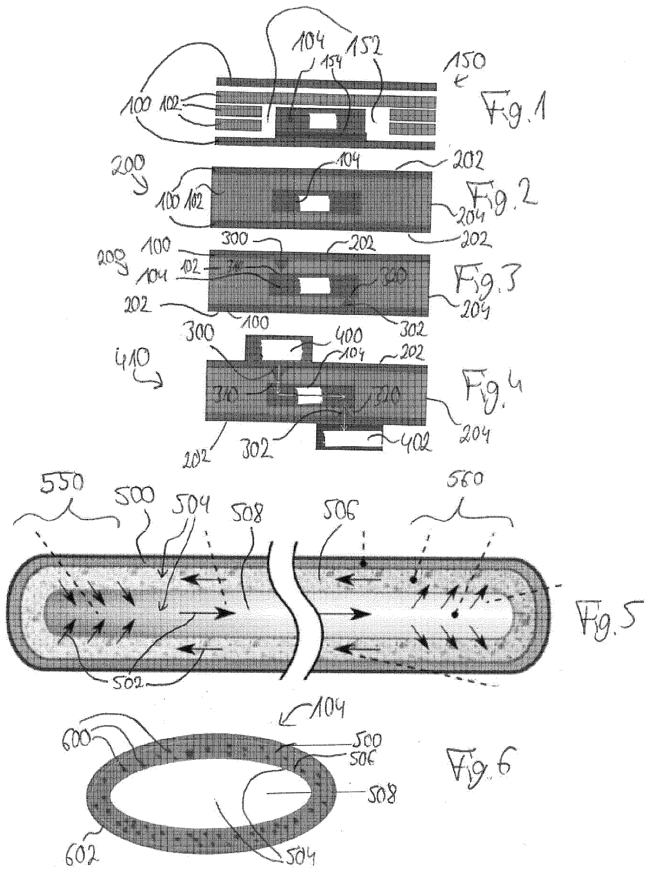

Figure 1 to Figure 4 illustrate cross sectional views of structures obtained during carrying out a method of manufacturing a circuit board 200 according to an exemplary embodiment of the invention.

**Figure 1** shows a structure 150 obtained during carrying out the method of manufacturing the circuit board 200 (as shown in Figure 2 and Figure 3). As can be taken from Figure 1, a plurality of layer structures 100, 102 of electrically insulating material and electrically conductive material are provided. In the shown embodiment, the layer structures 100 of electrically conductive material are copper foils. The layer structures 102 of electrically insulating material are prepreg foils. A part of the prepreg foils have been provided with through holes 152 together forming a cavity in which a hermetically sealed prefabricated heat pipe 104 is placed. The heat pipe 104 has been attached to a lower one of the electrically conductive layer structures 100 via thermally conductive (and optionally also the electrically conductive) adhesive 154 (or other appropriate material).

In order to obtain the circuit board 200 shown in **Figure 2****,** the structure 150 according to Figure 1 is pressed together in an embedding procedure for fully embedding the heat pipe 104 in an interior of the plurality of layer structures 100, 102. Consequently, circuit board 200 is obtained which comprises the plurality of connected layer structures 100, 102 of electrically insulating material and electrically conductive material, and the hermetically sealed prefabricated heat pipe 104 in contact with a part of the layer structures 100, 102. The circuit board 200 is configured as a printed circuit board (PCB) with integrated preformed heat pipe 104. The plate-shaped circuit board 200 has two-dimensional upper and lower main surfaces 202 and stripe-shaped lateral surfaces 204.

In order to obtain the further processed circuit board 200 shown in **Figure 3****,** a heat source coupling structure 300 is formed as a via made of thermally conductive and electrically conductive copper material. The heat source coupling structure 300 is configured for thermally coupling a first end portion 310 of the heat pipe 104 to a heat source mounting position of the circuit board 200 at which heat source mounting position at least one heat generating electronic component 400 (see Figure 4) is to be mounted in a later procedure. Moreover, a heat sink coupling structure 302 is formed as a further via which is also made of thermally conductive and electrically conductive copper material. The heat sink coupling structure 302 is configured for thermally coupling a second end portion 320 (opposing the above mentioned first end portion 310) of the heat pipe 104 to a heat sink mounting position of the circuit board 200 at which heat sink mounting position a heat sink 402 (see Figure 4), for instance a thermally conductive copper body, is to be mounted in a subsequent procedure.

In order to obtain electronic arrangement 410 shown in **Figure 4****,** a heat generating electronic component 400, here embodied as a microprocessor chip generating a large amount of heat during operation, is surface mounted on the upper main surface 202 of the circuit board 200 by soldering. Since the prefabricated heat pipe 104 is fully circumferentially embedded by material of the layer structures 100, 102, it is capable to withstand the high soldering temperature of for instance 220°C during soldering the electronic component 400 on the upper main surface 202 of the circuit board 200 without the risk that rapidly evaporating fluid 502 in an interior of the readily manufactured heat pipe 104 (compare Figure 5) generates a high pressure which might otherwise destroy an exterior shell of the heat pipe 104. Furthermore, the full embedding of the heat pipe 104 has the additional effect that it does not influence at all the assembly procedure of assembling the electronic component 400 by a pick and place apparatus (not shown). Due to a thermal coupling path from the electronic component 400 via the heat source coupling structure 300, to the first end portion 310 of the heat pipe 104, part of heat generated by the electronic component 400 is conducted away from the electronic component 400, which is thereby cooled. The thermal coupling path is continued through the heat pipe 104, to the second end portion 320 of the heat pipe 104, via the heat sink coupling structure 302 to the heat sink 402 mounted at the heat sink mounting position on the lower main surface 202 of the circuit board 200. The thermal coupling path or heat flow is schematically indicated in Figure 4 with arrows.

**Figure 5** illustrates a cross sectional view of a prefabricated heat pipe 104 for integration into layer structures 102, 104 for forming the circuit board 200 according to an exemplary embodiment of the invention.

The heat pipe 104, which is commercially available as a prefabricated member, comprises a thermally conductive exterior shell 500 which may be made for instance of copper, a fluid 502 (such as water) enclosed in an interior of the shell 500 and configured to be evaporated from a liquid phase into a gas phase (which may also be denoted as a vapor phase) in the presence of heat at a portion 550 of the shell 500. A guiding structure 504 comprising a porous body 506 (for instance sintered copper) in an interior of the shell 500 is configured for guiding the evaporated gas phase from said portion 550 to another cooler portion 560 of the shell 500 to thereby condense the fluid 502 from the gas phase back into the liquid phase, and for guiding back the condensed fluid 502 towards said portion 550. When the liquid evaporates in portion 550 at the first end of the heat pipe 104, it will automatically flow through a central cavity 508 of the guiding structure 504 to the lower pressure region close to the portion 560 at the second end of the heat pipe 104. Here, it will condense and will be drawn by capillary effects into the porous body 506 of the guiding structure 504 from where it may flow back towards the first end.

**Figure 6** illustrates a cross sectional view of a prefabricated heat pipe 104 reinforced by a reinforcement structure 600, 602 for attachment on layer structures 102, 104 for forming a circuit board 200 according to another exemplary embodiment of the invention.

The heat pipe 104 shown in Figure 6 may comprise the reinforcement structure 600, 602 which is configured for reinforcing mechanical stability of the heat pipe 104. The heat pipe can also be reinforced during the embedding process by the materials used in the embedding process such as epoxy filling. The reinforcement structure 600, 602 is configured so that the heat pipe 104 withstands a gas pressure of fluid 502 evaporated within an interior of the heat pipe 104 at least up to a temperature of 220°C, which may occur during a soldering procedure while assembling electronic components 400 on a circuit board 200.

In the shown embodiment, the reinforcement structure 600, 602 comprises reinforcement filler particles 600, in particular fibers, embedded in the shell 500 of the heat pipe 104. Additionally or alternatively, the mechanical strength of the heat pipe 104 may be increased by ion implantation. Additionally, the reinforcement structure 600, 602 comprises a reinforcement coating 602, for instance made of steel or diamond like carbon (DLC) surrounding the shell 500 of the heat pipe 104.

In view of the reinforcement of the heat pipe 104, which can be produced before contacting the heat pipe 104 with the layer structures 100, 102, the reinforced heat pipe 104 can also be attached to one of the exterior main surfaces 202 or the lateral surface 204 of the plurality of layer structures 100, 102, without the necessity of embedding it. It is even possible that a surface mounting, in particular by soldering, of one or more electronic component 400 on a main surface 202 of the circuit board 200 is accomplished after the attaching. It is even possible that the mounting of the reinforced heat pipe 104 itself is integrated into the pick and place procedure, i.e. that the reinforced heat pipe 104 is surface mounted on a main surface 202 of the circuit board 200 by soldering and can hence be handled by the same pick and place apparatus which also handles the electronic component 400 to be surface mounted on a main surface 202 of the circuit board 200.

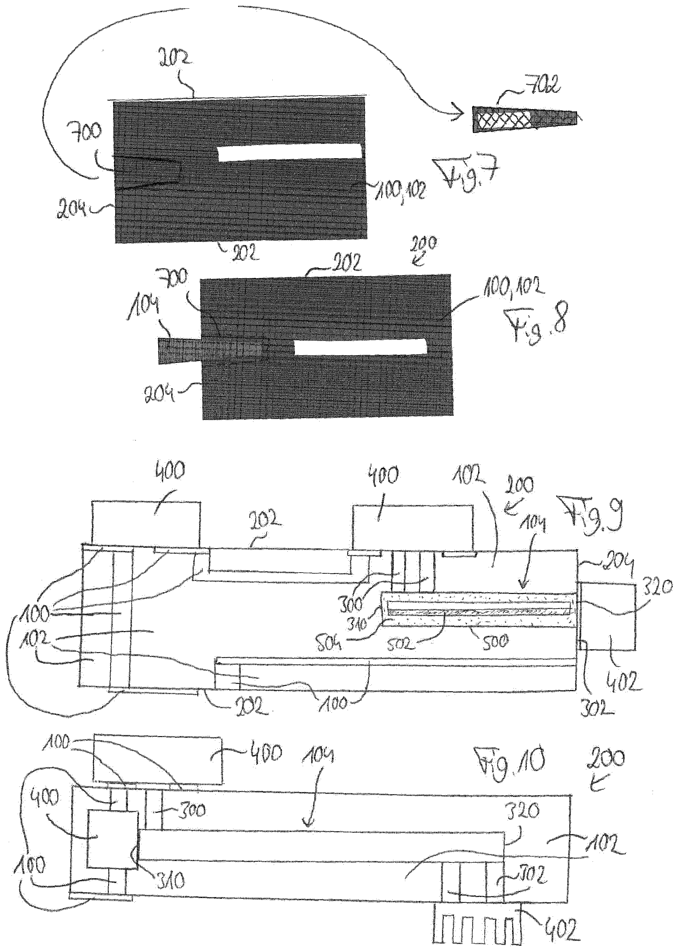

**Figure 7** and **Figure 8** illustrate cross sectional views of structures obtained during carrying out a method of manufacturing a circuit board 200 according to an example not belonging to the invention.

As can be taken from Figure 8, part of the heat pipe 104 can be arranged in a blind hole 700 formed in a lateral surface 204 of the plurality of layer structures 100, 102.

To accomplish this, and as can be taken from Figure 7, the manufacturing method further comprises forming the blind hole 700 in a surface portion of the plurality of layer structures 100, 102, and subsequently inserting the heat pipe 104 into the blind hole 700. For the purpose of the formation of the blind hole 700, the method comprises temporarily inserting a dummy structure 702 between the plurality of layer structures 100, 102 during connecting the layer structures 100, 102 to one another with the dummy structure 702 in between, and removing the dummy structure 702 from the plurality of connected layer structures 100, 102 after the connecting. Figure 7 hence shows the circuit board 200 with a lateral channel embodied as blind hole 700.

As an alternative to the use of the dummy structure 702, it is also possible to form the blind hole 700 by an abrasive technique such as mechanical drilling or laser drilling.

**Figure 9** and **Figure 10** illustrate cross sectional views of printed circuit boards 200.

According to Figure 9, the heat sink 402 is mounted at a heat sink mounting position located at a lateral surface 204 of the circuit board 200.

According to Figure 10, one of the electronic components 400 constituting heat sources is provided as an embedded component which is embedded in the layer structures 100, 102, while the other electronic component 400 is surface mounted.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible within the scope of the claims.

## Claims

1. A circuit board (200), wherein the circuit board (200) comprises:
a plurality of connected layer structures (100, 102) of electrically insulating material and electrically conductive material; and
a hermetically sealed prefabricated heat pipe (104) in contact with at least one of the layer structures (100, 102), said heat pipe (104) being fully embedded within an interior of the layer structures (100, 102),
wherein the heat pipe (104) comprises:
a thermally conductive exterior shell (500);
a fluid (502) enclosed in an interior of the shell (500) and configured to be evaporated from a liquid phase into a gas phase in the presence of heat at a portion of the shell (500);
a guiding structure (504) in an interior of the shell (500) configured for guiding the evaporated gas phase from said portion to another cooler portion of the shell (500) to thereby condense the fluid (502) from the gas phase into the liquid phase, and for guiding back the condensed fluid (502) towards said portion; **characterized by**
a reinforcement structure (600, 602) configured for reinforcing mechanical stability of the heat pipe (104),
wherein the reinforcement structure (600, 602) comprises a reinforcement coating (602) surrounding the shell (500) of the heat pipe (104), and
wherein the reinforcement structure (600, 602) comprises reinforcement filler particles (600), configured for increasing thermal conductivity of the shell (500) of the heat pipe (104), embedded in the shell (500) of the heat pipe (104).

2. The circuit board (200) according to claim 1, wherein the reinforcement structure (600, 602) is configured for withstanding a temperature of at least 220°C without failure, so that the heat pipe (104) withstands without failure a gas pressure of fluid (502) evaporated within an interior of the heat pipe (104) at least up to a temperature of 220°C.

3. The circuit board (200) according to any one of claims 1 to 2,
wherein the reinforcement filler particles (600) are made of at least one of the group consisting of polytetrafluoroethylene, carbon fibers, carbon nanotubes, Kevlar, and Nomex.

4. The circuit board (200) according to any one of claims 1 to 3,
wherein an exterior material of the shell (500) of the heat pipe (104) having a higher mechanical strength than an interior material of the guiding structure (504).

5. The circuit board (200) according to any one of the preceding claims,
wherein the circuit board (200) is configured as a printed circuit board (200).

6. The circuit board (200) according to any one of the preceding claims,
wherein the electrically insulating material comprises at least one of the group consisting of resin, in particular Bismaleimide-Triazine resin, glass fibers, prepreg material, polyimide, liquid crystal polymer, epoxy-based Build-Up Film, and FR4 material.

7. The circuit board (200) according to any one of the preceding claims,
Wherein the circuit board (200) comprises a heat source coupling structure (300) made of thermally conductive material and being configured for thermally coupling a portion of the heat pipe (104) to a heat source mounting position of the circuit board (200) at which heat source mounting position at least one heat generating electronic component (400) is to be mounted.

8. The circuit board (200) according to any of the preceding claims,
wherein the heat pipe (104) is configured and electrically connected to the electrically conductive material so that the heat pipe (104) provides an electric function.

9. An electronic arrangement (410), the electronic arrangement (410) comprising:
a circuit board (200) according to any of claims 1 to 8;
at least one heat generating electronic component (400) mounted on and/or in the circuit board (200) so that at least a part of heat generated by the at least one electronic component (400) is conducted away from the at least one electronic component (400) by the heat pipe (104).

10. A method of manufacturing a circuit board (200), wherein the method comprises:
connecting a plurality of layer structures (100, 102) of electrically insulating material and electrically conductive material; and
contacting a hermetically sealed prefabricated heat pipe (104) with at least one of the layer structures (100, 102) wherein
the heat pipe (104) is fully embedded within an interior of the layer structures (100, 102);
wherein manufacturing the hermetically sealed prefabricated heat pipe (104) comprises:
forming a thermally conductive exterior shell (500);
enclosing a fluid (502) in an interior of the shell (500), the fluid (502) being configured to be evaporated from a liquid phase into a gas phase in the presence of heat at a portion of the shell (500);
forming a guiding structure (504) in an interior of the shell (500) and configuring the guiding structure (504) for guiding the evaporated gas phase from said portion to another cooler portion of the shell (500) to thereby condense the fluid (502) from the gas phase into the liquid phase, and for guiding back the condensed fluid (502) towards said portion; and
forming a reinforcement structure (600, 602) for mechanically reinforcing the heat pipe (104),
wherein the reinforcement structure (600, 602) comprises a reinforcement coating (602) surrounding the shell (500) of the heat pipe (104), and
wherein the reinforcement structure (600, 602) comprises reinforcement filler particles (600), configured for increasing thermal conductivity of the shell (500) of the heat pipe (104), embedded in the shell (500) of the heat pipe (104).

11. The method according to claim 10,
wherein reinforcing the hermetically sealed prefabricated heat pipe (104) with the reinforcement structure (600, 602) is done before contacting the heat pipe (104) with the at least one of the layer structures (100, 102).

12. The method according to claim 10 or 11, wherein the method further comprises fully embedding the heat pipe (104) in an interior of the plurality of layer structures (100, 102) before or during the connecting.

13. The method according to claim 12,
wherein the method further comprises connecting the plurality of layer structures (100, 102) with the heat pipe (104) to be embedded by pressing together the plurality of layer structures (100, 102) and the heat pipe (104).

## Patentansprüche

1. Leiterplatte (200), wobei die Leiterplatte (200) Folgendes umfasst:
eine Vielzahl von verbundenen Schichtstrukturen (100, 102) aus elektrisch isolierendem Material und elektrisch leitfähigem Material; und
ein hermetisch abgedichtetes, vorgefertigtes Wärmerohr (104), das mit mindestens einer der Schichtstrukturen (100, 102) in Kontakt ist, wobei das Wärmerohr (104) vollständig in ein Inneres der Schichtstrukturen (100, 102) eingebettet ist, wobei das Wärmerohr (104) Folgendes umfasst:
eine wärmeleitende Außenhülle (500);
ein Fluid (502), das in einem Inneren der Hülle (500) eingeschlossen und dazu konfiguriert ist, dass es bei Vorhandensein von Wärme in einem Abschnitt der Hülle (500) von einer Flüssigphase in eine Gasphase verdampft wird;
eine Führungsstruktur (504) in einem Inneren der Hülle (500), die zum Führen der verdampften Gasphase von dem Abschnitt zu einem anderen kühleren Abschnitt der Hülle (500), um dadurch das Fluid (502) von der Gasphase in die Flüssigphase zu kondensieren, und zum Zurückführen des kondensierten Fluids (502) zu dem Abschnitt konfiguriert ist; **gekennzeichnet durch**
eine Verstärkungsstruktur (600, 602), die zum Verstärken der mechanischen Stabilität des Wärmerohrs (104) konfiguriert ist,
wobei die Verstärkungsstruktur (600, 602) eine Verstärkungsbeschichtung (602) umfasst, welche die Hülle (500) des Wärmerohrs (104) umgibt, und
wobei die Verstärkungsstruktur (600, 602) Verstärkungsfüllstoffpartikel (600) umfasst, die zum Erhöhen der Wärmeleitfähigkeit der Hülle (500) des Wärmerohrs (104) konfiguriert sind und in die Hülle (500) des Wärmerohrs (104) eingebettet sind.

2. Leiterplatte (200) nach Anspruch 1, wobei die Verstärkungsstruktur (600, 602) so konfiguriert ist, dass sie einer Temperatur von mindestens 220 °C ohne Versagen standhält, sodass das Wärmerohr (104) einem Gasdruck eines Fluids (502), das in einem Inneren des Wärmerohrs (104) verdampft ist, mindestens bis zu einer Temperatur von 220 °C ohne Versagen standhält.

3. Leiterplatte (200) nach einem der Ansprüche 1 bis 2, wobei die Verstärkungsfüllstoffpartikel (600) aus zumindest einer der Gruppe, bestehend aus Polytetrafluorethylen, Kohlenstofffasern, Kohlenstoff-Nanoröhrchen, Kevlar und Nomex, hergestellt sind.

4. Leiterplatte (200) nach einem der Ansprüche 1 bis 3, wobei ein Außenmaterial der Hülle (500) des Wärmerohrs (104) eine höhere mechanische Festigkeit aufweist als ein Innenmaterial der Führungsstruktur (504).

5. Leiterplatte (200) nach einem der vorhergehenden Ansprüche, wobei die Leiterplatte (200) als eine gedruckte Leiterplatte (200) konfiguriert ist.

6. Leiterplatte (200) nach einem der vorhergehenden Ansprüche, wobei das elektrisch isolierende Material zumindest eines von der Gruppe, bestehend aus Harz, insbesondere Bismaleimid-Triazin-Harz, Glasfasern, Prepreg-Material, Polyimid, Flüssigkristallpolymer, Build-Up-Folie auf Epoxidbasis und FR.4-Material, umfasst.

7. Leiterplatte (200) nach einem der vorhergehenden Ansprüche, wobei die Leiterplatte (200) eine Wärmequellen-Kopplungsstruktur (300) umfasst, die aus einem wärmeleitenden Material hergestellt und zum thermischen Koppeln eines Abschnitts des Wärmerohrs (104) mit einer Wärmequellen-Montageposition der Leiterplatte (200) konfiguriert ist, wobei an dieser Wärmequellen-Montageposition zumindest eine wärmeerzeugende elektronische Komponente (400) montiert werden soll.

8. Leiterplatte (200) nach einem der vorhergehenden Ansprüche, wobei das Wärmerohr (104) derart konfiguriert und elektrisch mit dem elektrisch leitfähigen Material verbunden ist, dass das Wärmerohr (104) eine elektrische Funktion bereitstellt.

9. Elektronische Anordnung (410), wobei die elektronische Anordnung (410) Folgendes umfasst:
eine Leiterplatte (200) nach einem der Ansprüche 1 bis 8;
mindestens eine wärmeerzeugende elektronische Komponente (400), die derart auf und/oder in der Leiterplatte (200) montiert ist, dass zumindest ein Teil der durch die mindestens eine elektronische Komponente (400) erzeugten Wärme durch das Wärmerohr (104) von der mindestens einen elektronischen Komponente (400) weggeleitet wird.

10. Verfahren zur Herstellung einer Leiterplatte (200), das Verfahren umfassend:
Verbinden einer Vielzahl von Schichtstrukturen (100, 102) aus elektrisch isolierendem Material und elektrisch leitfähigem Material; und
Inkontaktbringen eines hermetisch abgedichteten vorgefertigten Wärmerohrs (104) mit mindestens einer der Schichtstrukturen (100, 102), wobei
das Wärmerohr (104) vollständig in einem Inneren der Schichtstrukturen (100, 102) eingebettet ist;
wobei die Herstellung des hermetisch abgedichteten vorgefertigten Wärmerohrs (104) Folgendes umfasst:
Bilden einer wärmeleitenden Außenhülle (500);
Einschließen eines Fluids (502) in einem Inneren der Hülle (500), wobei das Fluid (502) so konfiguriert ist, dass es bei Vorhandensein von Wärme in einem Abschnitt der Hülle (500) aus einer Flüssigphase in eine Gasphase verdampft wird;
Bilden einer Führungsstruktur (504) in einem Inneren der Hülle (500) und Konfigurieren der Führungsstruktur (504) zum Führen der verdampften Gasphase von dem Abschnitt zu einem anderen kühleren Abschnitt der Hülle (500), um dadurch das Fluid (502) von der Gasphase in die Flüssigphase zu kondensieren, und zum Zurückführen des kondensierten Fluids (502) zu dem Abschnitt; und
Bilden einer Verstärkungsstruktur (600, 602) zum mechanischen Verstärken des Wärmerohrs (104), wobei die Verstärkungsstruktur (600, 602) eine Verstärkungsbeschichtung (602) umfasst, welche die Hülle (500) des Wärmerohrs (104) umgibt, und wobei die Verstärkungsstruktur (600, 602) Verstärkungsfüllstoffpartikel (600) umfasst, die zum Erhöhen der Wärmeleitfähigkeit der Hülle (500) des Wärmerohrs (104) konfiguriert und in die Hülle (500) des Wärmerohrs (104) eingebettet sind.

11. Verfahren nach Anspruch 10,
wobei das Verstärken des hermetisch abgedichteten vorgefertigten Wärmerohrs (104) mit der Verstärkungsstruktur (600, 602) vor dem Inkontaktbringen des Wärmerohrs (104) mit der zumindest einen der Schichtstrukturen (100, 102) erfolgt.

12. Verfahren nach Anspruch 10 oder 11, wobei das Verfahren ferner das vollständige Einbetten des Wärmerohrs (104) in ein Inneres der Vielzahl von Schichtstrukturen (100, 102) vor oder während des Verbindens umfasst.

13. Verfahren nach Anspruch 12,
wobei das Verfahren ferner das Verbinden der Vielzahl von Schichtstrukturen (100, 102) mit dem einzubettenden Wärmerohr (104) durch Zusammenpressen der Vielzahl von Schichtstrukturen (100, 102) und des Wärmerohrs (104) umfasst.

## Revendications

1. Carte de circuit (200), dans laquelle la carte de circuit (200) comprend :
une pluralité de structures en couches connectées (100, 102) de matériau électro-isolant et de matériau électroconducteur ; et
un caloduc préfabriqué hermétiquement scellé (104) en contact avec au moins l'une des structures en couches (100, 102), ledit caloduc (104) étant entièrement encastré au sein des structures en couches (100, 102), dans laquelle le caloduc (104) comprend :
une coque (500) extérieure thermoconductrice ;
un fluide (502) enfermé à l'intérieur de la coque (500) et configuré pour être évaporé d'une phase liquide dans une phase gazeuse en présence de chaleur au niveau d'une portion de la coque (500) ;
une structure de guidage (504) à l'intérieur de la coque (500) configurée pour guider la phase gazeuse évaporée depuis ladite portion vers une autre portion plus froide de la coque (500) pour ainsi condenser le fluide (502) provenant de la phase gazeuse dans la phase liquide, et pour guider en retour le fluide (502) condensé vers ladite portion ; **caractérisée par**
une structure de renforcement (600, 602) configurée pour renforcer la stabilité mécanique du caloduc (104),
dans laquelle la structure de renforcement (600, 602) comprend un revêtement de renforcement (602) entourant la coque (500) du caloduc (104), et
dans laquelle la structure de renforcement (600, 602) comprend des particules de charge de renforcement (600), configurées pour augmenter la conductivité thermique de la coque (500) du caloduc (104), encastré dans la coque (500) du caloduc (104).

2. Carte de circuit (200) selon la revendication 1, dans laquelle la structure de renforcement (600, 602) est configurée pour supporter une température d'au moins 220 °C sans défaillance, de sorte que le caloduc (104) supporte sans défaillance une pression de gaz du fluide (502) évaporé à l'intérieur du caloduc (104) au moins jusqu'à une température de 220 °C.

3. Carte de circuit (200) selon l'une quelconque des revendications 1 à 2, dans laquelle les particules de charge de renforcement (600) sont composées d'au moins l'un parmi le groupe constitué du polytétrafluoroéthylène, des fibres de carbone, des nanotubes de carbone, du Kevlar et du Nomex.

4. Carte de circuit (200) selon l'une quelconque des revendications 1 à 3, dans laquelle un matériau extérieur de la coque (500) du caloduc (104) a une résistance mécanique supérieure à celle d'un matériau intérieur de la structure de guidage (504).

5. Carte de circuit (200) selon l'une quelconque des revendications précédentes, dans laquelle la carte de circuit (200) est configurée comme une carte de circuit imprimé (200).

6. Carte de circuit (200) selon l'une quelconque des revendications précédentes, dans laquelle le matériau électro-isolant comprend au moins l'un parmi le groupe constitué d'une résine, en particulier une résine de bismaléimide-triazine, des fibres de verre, un matériau préimprégné, un polyimide, un polymère à cristaux liquides, un film d'accroissement à base époxy et un matériau FR.4.

7. Carte de circuit (200) selon l'une quelconque des revendications précédentes, dans laquelle la carte de circuit (200) comprend une structure de couplage de source de chaleur (300) composée d'un matériau thermoconducteur et configurée pour coupler thermiquement une portion du caloduc (104) à une position de montage de source de chaleur de la carte de circuit (200), au niveau de laquelle position de montage de source de chaleur au moins un composant électronique de génération de chaleur (400) doit être monté.

8. Carte de circuit (200) selon l'une quelconque des revendications précédentes, dans laquelle le caloduc (104) est configuré et raccordé électriquement au matériau électroconducteur de sorte que le caloduc (104) fournit une fonction électrique.

9. Agencement électronique (410), l'agencement électronique (410) comprenant :
une carte de circuit (200) selon l'une quelconque des revendications 1 à 8 ;
au moins un composant électronique de génération de chaleur (400) monté sur et/ou dans la carte de circuit (200) de telle sorte qu'au moins une partie de la chaleur générée par l'au moins un composant électronique (400) est évacuée de l'au moins un composant électronique (400) par le caloduc (104).

10. Procédé de fabrication d'une carte de circuit (200), dans lequel le procédé comprend :
le raccordement d'une pluralité de structures en couches (100, 102) de matériau électro-isolant et de matériau électroconducteur ; et
la mise en contact d'un caloduc préfabriqué hermétiquement scellé (104) avec au moins une des structures en couches (100, 102) dans lequel
le caloduc (104) est entièrement encastré à l'intérieur des structures en couches (100, 102) ;
dans lequel la fabrication du caloduc préfabriqué hermétiquement scellé (104) comprend :
la formation d'une coque (500) extérieure thermoconductrice ;
le fait d'enfermer un fluide (502) à l'intérieur de la coque (500), le fluide (502) étant configuré pour être évaporé d'une phase liquide dans une phase gazeuse en présence de chaleur au niveau d'une portion de la coque (500) ;
la formation d'une structure de guidage (504) à l'intérieur de la coque (500) et la configuration de la structure de guidage (504) pour guider la phase gazeuse évaporée depuis ladite portion vers une autre portion plus froide de la coque (500) pour ainsi condenser le fluide (502) provenant de la phase gazeuse dans la phase liquide, et pour guider en retour le fluide (502) condensé vers ladite portion ; et
la formation d'une structure de renforcement (600, 602) pour renforcer mécaniquement le caloduc (104), dans lequel la structure de renforcement (600, 602) comprend un revêtement de renforcement (602) entourant la coque (500) du caloduc (104), et dans lequel la structure de renforcement (600, 602) comprend des particules de charge de renforcement (600), configurées pour augmenter la conductivité thermique de la coque (500) du caloduc (104), encastré dans la coque (500) du caloduc (104).

11. Procédé selon la revendication 10,
dans lequel le renforcement du caloduc préfabriqué hermétiquement scellé (104) avec la structure de renforcement (600, 602) est réalisé avant la mise en contact du caloduc (104) avec l'au moins une des structures en couches (100, 102).

12. Procédé selon la revendication 10 ou 11, dans lequel le procédé comprend en outre l'encastrement complet du caloduc (104) à l'intérieur de la pluralité de structures en couches (100, 102) avant ou pendant le raccordement.

13. Procédé selon la revendication 12,
dans lequel le procédé comprend en outre le raccordement de la pluralité de structures en couches (100, 102) avec le caloduc (104) à encastrer en pressant ensemble la pluralité de structures en couches (100, 102) et le caloduc (104).
